# EUROPEAN PATENT APPLICATION

(11) **EP 4 647 528 A1**
(43) Date of publication of application: **12.11.2025**
(21) Application number: 23914824.0
(22) Date of filing: 28.12.2023
(51) Int. Cl.: C23C 16/42, H01L 21/205

(54) **SIC-CONTAINING FILM, AND METHOD FOR MANUFACTURING SAME**

(30) Priority: 05.01.2023 JP 2023000550
(71) Applicant: Toagosei Co., Ltd., Minato-ku Tokyo 105-8419 (JP); Japan Advanced Chemicals Ltd., Atsugi-Shi, Kanagawa 243-0801 (JP)
(72) Inventor: SUMITA, Masanao, Tokyo 105-8419 (JP); MIYAUCHI, Kazuhiro, Tokyo 105-8419 (JP); OOTSUKI, Akimichi, Nagoya-shi, Aichi 455-0026 (JP); YASUHARA, Shigeo, Kanagawa 2430801 (JP); NOZU, Sadao, Kanagawa 2430801 (JP); ZAITSU, Masaru, Kanagawa 2430801 (JP)
(74) Representative: Dompatent Partnerschaft von Patent- und Rechtsanwälten mbB
(86) International application number: PCT/JP2023/047308
(87) International publication number: WO 2024/147339

(57) **Abstract**

The present invention is directed to providing, for example, a novel production method capable of highly efficiently and conformally depositing a SiC-containing film having a relatively high content ratio of a silicon atom by a production process with high productivity. The present invention provides a method for producing a SiC-containing film, comprising the steps of: providing XpHnSim-C≡C-SiqHrXs (wherein m is an integer of 0 or larger and 4 or smaller, each of n and p is an integer of 0 or larger and 2m + 1 or smaller and satisfies n + p = 2m + 1, q is an integer of 1 or larger and 4 or smaller, each of r and s is an integer of 0 or larger and 2q + 1 or smaller and satisfies r + s = 2q + 1, and each X is independently a halogen element selected from F, Cl, Br, and I) as a starting material gas (S1 step); and supplying the starting material gas into a chamber containing a workpiece having a surface for film deposition, and depositing a SiC-containing film on the surface for film deposition by a chemical vapor deposition method or an atomic layer deposition method through thermal reaction, the SiC-containing film comprising Si and C as main components, wherein a ratio of the number of silicon atoms to the number of carbon atoms (Si/C) is 0.70 or more (S2 step).

## Description

### Technical Field

The present invention relates to, for example, a SiC-containing film and a method for producing the same.

### Background Art

Films of SiC (silicon carbide), which is a compound semiconductor having a larger energy band gap and a higher electron mobility than those of Si or GaAs, are materials expected to be used as semiconductor elements such as next-generation compound semiconductors, next-generation electronic elements, electronic elements operable at high speeds and high temperatures, or photovoltaic power elements, together with or as replacements for Si films, GaAs films, GaN films, or the like. However, SiC has 200 or more crystal polymorphs, and physical property values of SiC differ largely depending on the crystal polymorphs, and the crystal polymorphs are not easy to control at present. Along with these factors, industrial use of SiC as a semiconductor element is limited. For example, most of the currently commercially available SiC single-crystal wafers are produced by sublimation-recrystallization. For example, in the case of performing crystal growth at a temperature as high as 1000 to 2500°C, as in the sublimation-recrystallization method, energy cost is large and productivity is poor. In addition, during the course of growth, micropipes or low-angle grain boundaries occur easily or mixed crystals of 4H-SiC, 6H-Si, and 15R-SiC based on the Ramsdell notation occur easily. Such crystal irregularities generate a lot of defects and make it difficult to obtain SiC films excellent in crystal quality.

On the other hand, a gas growth method is expected to be able to continuously perform the growth of high-quality crystals at a high speed because the flow rate of a starting material gas can be controlled. However, a conventional technique using an organic silane-based material such as SiH₄ and a hydrocarbon-based gas such as C₃H₈ as starting materials requires reaction at a high temperature and thus large energy cost. Furthermore, molecular species near the surface of grown crystals are difficult to control because molecular species after decomposition vary. Under these circumstances, SiC-containing films (silicon carbide-containing films) are excellent in mechanical strength, heat resistance, and corrosion resistance, even if not made of single crystals, and give low permittivity and high heat conductivity. Hence, various studies have been made on their utilization as semiconductor elements or for applications other than semiconductor elements.

For example, Patent Literature 1 discloses a method for preparing an organic insulating film for use as an insulating film in semiconductor devices, wherein a film deposition method by plasma CVD is used, and gases used at the time of film deposition are an organic silane gas having a carbon triple bond, an oxidizing agent, and an inert gas. The literature states that disilylacetylene, bistrimethylsilylacetylene, or trimethylsilylacetylene is used as the organic silane, and films obtained using these gases are SiCH films or SiCNH films having a Si-H bond but having no Si-OH bond.

Patent Literature 2 discloses a method for producing a gas barrier plastic molded body, comprising a film deposition step of forming a gas barrier thin film by a heating element CVD method of contacting a starting material gas with a heated heating element so that the starting material gas is decomposed to generate chemical species, and allowing the chemical species to arrive at the surface of a plastic molded body, wherein an organic silane compound represented by the general formula (Formula 1) H₃Si-CnX (wherein n is 2 or 3, and X is SiH₃, H, or NH₂) is used as the starting material gas, a material containing one or two or more metal elements selected from the group consisting of Mo, W, Zr, Ta, V, Nb, and Hf is used as the heating element, and a heating temperature of the heating element is set to 1550 to 2400°C. The literature states that vinylsilane, disilabutane, disilylacetylene, or 2-aminoethylsilane is used as the organic silane compound, and films obtained using these compounds are SiOCH films having a Si-H bond.

### Citation List

### Patent Literature

Patent Literature 1: Japanese Patent Laid-Open No. 2007-088017
Patent Literature 2: International Publication No. WO 2012/091097

### Summary of Invention

### Technical Problem

According to the findings of the present inventors, SiC-containing films are expected to be utilized not only as insulating films having low permittivity and gas barrier films as mentioned above but for applications, for example, covering materials such as graphite members, carbon fibers, and SiC fibers, embedded layers in the surroundings of wiring or each element within semiconductor devices, fine multilayer-structure films or various protective films in large-scale integrated circuits and the like for use in semiconductors, interlayer insulating films, etching stopper films, barrier insulating films, waveguides or their protective films, and electrode materials.

Meanwhile, it is required that a bond other than a Si-C bond in SiC-containing films obtained by a gas growth method or a CVD method using an organic silane-based material should be minimized from the viewpoint of controlling various physical properties of SiC-containing films and enhancing the functionality thereof. For example, too large a ratio of a silicon atom in a starting material gas increases the number of Si-Si bonds in a film. Too large a ratio of a carbon atom in a starting material gas tends to increase the number of C-C bonds in a film. As a result, a band gap in the film is no longer constant due to the level of these impurities and affects the electric characteristics or optical characteristics of the resulting film. Likewise, it is also required that bonds of Si or C with other atoms should be minimized. Particularly, SiC-containing films having no Si-H bond or C-H bond are demanded. The gas growth method or the CVD method using an organic silane-based material still has a room for improvements such as lowering temperatures, reduction in energy cost, or improvement in productivity.

However, Patent Literature 1 is inferior in productivity from an industrial standpoint because plasma CVD having relatively low utilization efficiency of a starting material gas is used. The plasma CVD tends to have the difficulty in controlling the compositional ratio of a film with increase in the area of a surface for film deposition. Furthermore, its application in various applications is limited because film deposition is difficult for the reverse side or a deep moiety of structures, which is not exposed to plasma. Moreover, Patent Literature 1, in the first place, is aimed to obtain a SiCH or SiCNH film, and the resulting film contains a Si-H bond and a C-H bond.

On the other hand, Patent Literature 2 provides a gas barrier plastic molded body having high gas barrier and is inferior in productivity from an industrial standpoint in terms of a film deposition temperature because heating element CVD involving a temperature as high as 1550 to 2400°C is used. Furthermore, even if the technique described in Patent Literature 2 is used to deposit a SiC-containing film on a Si substrate or the like, it is easily anticipated that thermal strain occurs during cooling after thin film deposition at a high temperature and induces deterioration in physical properties of the resulting film or mechanical breakdown. Moreover, Patent Literature 2, in the first place, is aimed to obtain a SiOCH film, and the resulting film contains a Si-H bond.

The present invention has been made in light of the problems described above. Specifically, an object of the present invention is to provide, for example, a novel production method capable of highly efficiently and conformally depositing a SiC-containing film having a relatively high content ratio of a silicon atom by a production process with high productivity, i.e., at a favorable film deposition rate without excessively elevating a film deposition temperature. Another object of the present invention is to provide, for example, a SiC-containing film having a relatively high content ratio of a silicon atom.

In addition to the objects described herein, an alternative object of the present invention can be to provide working effects that are brought about by each constituent shown in Description of Embodiments mentioned later and cannot be obtained by conventional techniques.

### Solution to Problem

The present inventors have conducted diligent studies to attain the objects. As a result, the present inventors have completed the present invention by finding that a SiC-containing film having a relatively large ratio of a silicon atom can be produced by using a predetermined compound as a precursor.

Specifically, the present invention provides various specific aspects given below.
(1) A method for producing a SiC-containing film, comprising the steps of:
   providing XpHnSim-C≡C-SiqHrXs (wherein m is an integer of 0 or larger and 4 or smaller, each of n and p is an integer of 0 or larger and 2m + 1 or smaller and satisfies n + p = 2m + 1, q is an integer of 1 or larger and 4 or smaller, each of r and s is an integer of 0 or larger and 2q + 1 or smaller and satisfies r + s = 2q + 1, and each X is independently a halogen element selected from F, Cl, Br, and I) as a starting material gas; and
   supplying the starting material gas into a chamber containing a workpiece having a surface for film deposition, and depositing a SiC-containing film on the surface for film deposition by a chemical vapor deposition method or an atomic layer deposition method through thermal reaction, the SiC-containing film comprising Si and C as main components, wherein a ratio of the number of silicon atoms to the number of carbon atoms (Si/C) is 0.70 or more.
(2) The method for producing a SiC-containing film according to (1), wherein
   in the film deposition step, the SiC-containing film is deposited in an inert gas atmosphere and/or in a hydrogen gas atmosphere.
(3) The method for producing a SiC-containing film according to (1) or (2), wherein
   the SiC-containing film comprises 50.0 atm% or more and 99.0 atm% or less of Si and C in total.
(4) The method for producing a SiC-containing film according to any one of (1) to (3), wherein
   the SiC-containing film substantially comprises no C-H bond.
(5) The method for producing a SiC-containing film according to any one of (1) to (4), wherein
   the SiC-containing film substantially comprises no nitrogen atom.
(6) The method for producing a SiC-containing film according to any one of (1) to (5), wherein
   the ratio (Si/C) of the SiC-containing film is 0.70 or more and 0.99 or less.
(7) The method for producing a SiC-containing film according to any one of (1) to (6), wherein
   in the film deposition step, the SiC-containing film is deposited under a condition of 300°C or higher.
(8) The method for producing a SiC-containing film according to any one of (1) to (7), wherein
   in the film deposition step, the SiC-containing film is deposited under a condition of 1200°C or lower.
(9) A SiC-containing film
   comprising Si and C as main components, wherein a ratio of the number of silicon atoms to the number of carbon atoms (Si/C) is 0.70 or more.
(10) The SiC-containing film according to (9), wherein
   the SiC-containing film is derived from XpHnSim-C≡C-SiqHrXs (wherein m is an integer of 0 or larger and 4 or smaller, each of n and p is an integer of 0 or larger and 2m + 1 or smaller and satisfies n + p = 2m + 1, q is an integer of 1 or larger and 4 or smaller, each of r and s is an integer of 0 or larger and 2q + 1 or smaller and satisfies r + s = 2q + 1, and each X is independently a halogen element selected from F, Cl, Br, and I).
(11) The SiC-containing film according to (9) or (10), wherein
   the SiC-containing film comprises 50.0 atm% or more and 99.0 atm% or less of Si and C in total.
(12) The SiC-containing film according to any one of (9) to (11), wherein
   the SiC-containing film substantially comprises no C-H bond.
(13) The SiC-containing film according to any one of (9) to (12), wherein
   the SiC-containing film substantially comprises no nitrogen atom.
(14) The SiC-containing film according to any one of (9) to (13), wherein
   the ratio (Si/C) is 0.70 or more and 0.99 or less.

### Advantageous Effect of Invention

The present invention can achieve a SiC-containing film having a relatively high content ratio of a silicon atom. The present invention is advantageous for the control of SiC single-crystal growth by a gas growth method because the flow rate of a highly pure starting material gas can be precisely controlled and a few types of reactive molecular species can be generated at a relatively low temperature. Hence, the present invention is expected to be utilized in SiC single-crystal wafer preparation and epitaxial growth. Furthermore, the present invention enables the SiC-containing film described above to be deposited highly efficiently and conformally by a production process with high productivity. Therefore, the resulting SiC-containing film requires low cost and is excellent in economic performance.

### Brief Description of Drawings

[Figure 1] Figure 1 is a flow chart showing the method for producing a SiC-containing film according to the present embodiment.
[Figure 2] Figure 2 is a schematic view showing one example of a film deposition apparatus 100 for the SiC-containing film of the present embodiment.
[Figure 3] Figure 3 is a chart showing IR measurement results of Examples 1 and 2.
[Figure 4] Figure 4 is a chart showing IR measurement results of Comparative Examples 1 to 4.

### Description of Embodiments

Hereinafter, the mode for carrying out the present invention will be described in detail with reference to the drawings. However, the embodiments given below are illustrations for describing the present invention, and the present invention is not limited by these embodiments. Specifically, the present invention can be carried out through arbitrary changes or modifications made without departing from the subject matter of the present invention. In the present specification, positional relationships indicated by terms such as "up", "down", "right", and "left" are based on positional relationships shown in the drawings, unless otherwise specified. The dimensional ratios of the drawings are not limited to ratios shown therein. In the present specification, the term "to" used to designate numeric values or physical property values between which the term exists includes the values therebetween. For example, the notation of the numeric range of "1 to 100" includes both of the lower limit value "1" and the upper limit value "100". The same holds true for the notation of other numeric ranges.

### [Method for producing SiC-containing film]

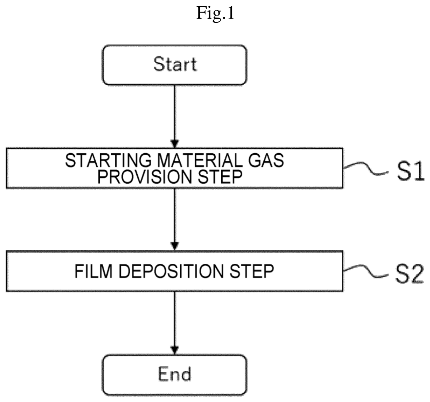

Figure 1 is a flow chart showing the method for producing a SiC-containing film according to the present embodiment. The method for producing a SiC-containing film according to the present embodiment comprises the steps of: providing XpHnSim-C≡C-SiqHrXs (wherein m is an integer of 0 or larger and 4 or smaller, each of n and p is an integer of 0 or larger and 2m + 1 or smaller and satisfies n + p = 2m + 1, q is an integer of 1 or larger and 4 or smaller, each of r and s is an integer of 0 or larger and 2q + 1 or smaller and satisfies r + s = 2q + 1, and each X is independently a halogen element selected from F, Cl, Br, and I) as a starting material gas (starting material gas provision S1); and supplying the starting material gas into a chamber containing a workpiece having a surface for film deposition, and depositing a SiC-containing film on the surface for film deposition by a chemical vapor deposition method or an atomic layer deposition method through thermal reaction, the SiC-containing film comprising Si and C as main components, wherein a ratio of the number of silicon atoms to the number of carbon atoms (Si/C) is 0.70 or more (film deposition step S2).

### (Starting material gas provision step S1)

In this starting material gas provision step S1, organic silane having a silylacetylene structure is provided as a starting material gas. In this context, the organic silane for use as a starting material gas is specifically XpHnSim-C≡C-SiqHrXs (wherein m is an integer of 0 or larger and 4 or smaller, each of n and p is an integer of 0 or larger and 2m + 1 or smaller and satisfies n + p = 2m + 1, q is an integer of 1 or larger and 4 or smaller, each of r and s is an integer of 0 or larger and 2q + 1 or smaller and satisfies r + s = 2q + 1, and each X is independently a halogen element selected from F, Cl, Br, and I). The organic silane represented by the above formula has no carbon atom other than the -C≡C- group (alkynylene group having 2 carbon atoms) in the silylacetylene structure and therefore facilitates obtaining a SiC-containing film having a relatively large ratio of a silicon atom. The organic silane represented by the above formula has relatively high safety and a relatively low pyrolysis temperature. Therefore, use of this compound as a precursor for the SiC-containing film enables the desired SiC-containing film to be deposited at a favorable film deposition rate without excessively elevating a film deposition temperature, independently from a plasma CVD method. In this context, in the formula, m is preferably 0 or larger and 3 or smaller, more preferably 0 or larger and 2 or smaller, further preferably 0 or larger and 1 or smaller. In the formula, q is preferably 1 or larger and 3 or smaller, more preferably 1 or larger and 2 or smaller, further preferably 1. In the formula, n and r are each independently preferably 0 or larger and 9 or smaller, more preferably 1 or larger and 5 or smaller, further preferably 1 or larger and 3 or smaller. In the formula, p and s are each independently preferably 0 or larger and 6 or smaller, more preferably 0 or larger and 3 or smaller. The halogen element of X is preferably F or Cl, more preferably Cl. X (halogen element) in the formula can be contained or not contained to adjust a film deposition rate, a film deposition temperature, or the like. Specific examples of the preferred organic silane include disilylacetylene (DSA: H₃Si-C≡C-SiH₃) wherein m = 1, n = 3, p = 0, q = 1, r = 3, and s = 0, and bistrichlorosilylacetylene (BTCSA: Cl₃Si-C≡C-SiCl₃) wherein m = 1, n = 0, p = 3, q = 1, r = 0, s = 3, and X is Cl.

### (Film deposition step S2)

In this film deposition step S2, a SiC-containing film comprising Si and C as main components, wherein a ratio of the number of silicon atoms to the number of carbon atoms (Si/C) is 0.70 or more, is deposited on a surface for film deposition of a workpiece using the aforementioned starting material gas. Hereinafter, more details will be described.

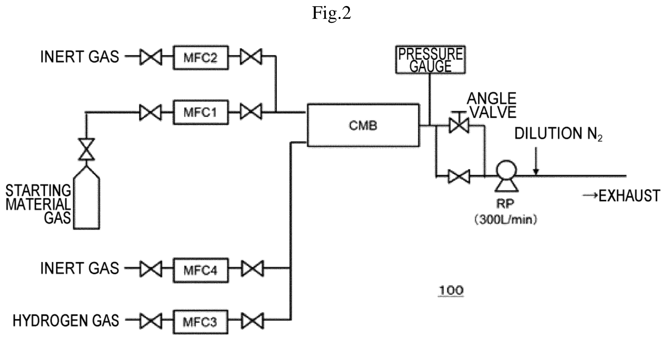

Figure 2 is a schematic view showing one example of a film deposition apparatus 100 for the SiC-containing film of the present embodiment. This production apparatus 100 has a chamber CMB (film deposition chamber) containing a workpiece having a surface for film deposition for depositing a SiC-containing film on the surface for film deposition. In the chamber CMB, a substrate serving as a workpiece fixed to a susceptor is loaded at the center. The chamber CMB has a hot wall-type and/or cold wall-type heater. The hot wall-type heater controls the chamber CMB at a predetermined temperature by heating the whole chamber CMB. The cold wall-type heater controls the workpiece disposed in the chamber CMB at a predetermined temperature. Such control can heat the substrate, for example, from room temperature to 1200°C and thereby enables the desired film deposition temperature to be set.

The upstream side of the chamber CMB is connected with a starting material gas supply passage that introduces the starting material gas into the chamber CMB, via a mass flow controller MFC1 that performs flow rate control, and a valve. In the case of using a plurality of starting material gases, an additional starting material gas supply passage can be connected to the chamber CMB via a mass flow controller that performs flow rate control, and a valve. The chamber CMB is also connected on the upstream side with each process gas supply passage that introduces an inert gas (e.g., an Ar gas) or a hydrogen gas as a process gas into the chamber CMB, via a mass flow controller MFC2, MFC3, or MFC4 that performs flow rate control, and a valve. In this example, the starting material gas is appropriately diluted with an inert gas such as an Ar gas and introduced into the chamber CMB. Also, the hydrogen gas is appropriately mixed with an inert gas such as an Ar gas and introduced into the chamber CMB.

On the other hand, the downstream side of the chamber CMB is connected with a gas exhaust passage that exhausts an excess of the starting material gas, the process gas, or the like, via a rotary pump R.P and a valve. The gas exhaust passage is connected with a pressure gauge that monitors the inner pressure of the chamber CMB, and the inner pressure of the chamber CMB is adjustable by the opening and closing of an angle valve. The gas exhaust passage is also connected with a dilution gas supply passage, and various gases supplied into the chamber CMB are aspirated by the rotary pump R.P, then flow in the dilution gas supply passage, diluted, if necessary, into an arbitrary ratio with a dilution gas, and exhausted to an external gas recovery mechanism (not shown). The inner pressure of the chamber CMB can also be adjusted by the rotary pump R.P or the angle valve. For example, the inside of the chamber CMB can be adjusted to a reduced-pressure atmosphere.

In the film deposition process using this film deposition apparatus 100, a workpiece having a surface for film deposition is first disposed in the chamber CMB, which is purged, if necessary, by the supply of a process gas such as an inert gas or a hydrogen gas. While a temperature is controlled to a predetermined film deposition temperature, the aforementioned organic silane serving as a starting material gas is introduced into the chamber CMB from the starting material gas supply passage. Then, in this chamber CMB, a SiC-containing film is deposited on the surface for film deposition by a chemical vapor deposition method or an atomic layer deposition method through thermal reaction at the desired film deposition temperature. An excess of various gases flowing in the chamber CMB is aspirated by the rotary pump R.P or the angle valve with a predetermined pressure retained, and exhausted from the gas exhaust passage as mentioned above.

The film deposition atmosphere in the film deposition step S2 is not particularly limited and is preferably an inert gas atmosphere from the viewpoint of safety or the like for using the aforementioned organic silane as a starting material gas, and preferably a hydrogen gas atmosphere from the viewpoint of, for example, depositing a film having few defects by hydrogenation or promoting low-temperature film deposition by hydrogen dissociation. In consideration of these, the film deposition atmosphere in the film deposition step S2 can also be an inert gas and hydrogen gas atmosphere. In the present specification, the inert gas means He, Ne, Ar, Kr, or N₂. Among them, the inert gas is preferably He, Ne, Ar, or Kr from the viewpoint of preventing nitriding reaction. The film deposition atmosphere is preferably a nonoxidative atmosphere containing none of O₃, O₂, CO, CO₂, H₂O, H₂O₂, N₂O, and the like.

The film deposition temperature in the film deposition step S2 is not particularly limited and is preferably 300°C or higher. Since the aforementioned organic silane is used as a starting material gas, the desired SiC-containing film can be deposited at a favorable film deposition rate without excessively elevating the film deposition temperature, independently from a plasma CVD method. The film deposition temperature is more preferably 400°C or higher, further preferably 500°C or higher. On the other hand, the upper limit value of the film deposition temperature is not particularly limited and is preferably 1200°C or lower, more preferably 1000°C or lower, further preferably 800°C or lower. In the present specification, the film deposition temperature means the surface temperature of the surface for film deposition of the workpiece and means a value measured in a contact surface thermometer.

The film deposition pressure in the film deposition step S2 is not particularly limited and may be ordinary pressure, increased pressure, or reduced pressure. For example, the reduced-pressure condition is preferably 0.05 Torr to 760 Torr, more preferably 0.05 Torr to 10 Torr, from the viewpoint of the compactness, uniformity, conformality (uniform film deposition against asperities), or the like of the film.

The film deposition mode in the film deposition step S2 can be a chemical vapor deposition (CVD) method or an atomic layer deposition (ALD) method through thermal reaction and is not particularly limited. Specific examples thereof include thermal CVD, thermal ALD, and plasma ALD. Among them, thermal CVD or thermal ALD is preferred from the viewpoint of productivity or economic performance.

The introduction flow rate of the starting material gas in the film deposition step S2 is not particularly limited and is preferably 0.1 to 10 sccm, more preferably 0.5 to 5 sccm, further preferably 1 to 3 sccm. The introduction flow rate is 0.1 sccm or more, whereby film deposition tends to progress efficiently. The introduction flow rate is 10 sccm or less, whereby the resulting film tends to be excellent in compactness, uniformity, and conformality.

The introduction flow rate of the inert gas in the film deposition step S2 is not particularly limited and is preferably 1 to 500 sccm, more preferably 10 to 300 sccm, further preferably 50 to 100 sccm.

The introduction flow rate of the hydrogen gas in the film deposition step S2 is not particularly limited and is preferably 0.1 to 10000 sccm, more preferably 10 to 1000 sccm, further preferably 50 to 200 sccm.

The workpiece is not particularly limited by its type as long as the SiC-containing film can be deposited. In the example described above, a substrate is described as the workpiece. Examples thereof include, but are not particularly limited to, semiconductor products such as silicon wafers, quartz, glass, titanium, aluminum, SUS, and iron steel materials, electrode materials, optical materials, and mechanical reinforcement materials. The surface for film deposition is not particularly limited by its type as long as the SiC-containing film can be deposited. In the example described above, the surface of the workpiece is described as the surface for film deposition. Examples thereof include, but are not particularly limited to, silicon wafer surface, SiO₂ films, SiN films, GaN films, and polysilicon films deposited on silicon wafer surface, metal materials such as SUS and copper, noble metals such as platinum, ruthenium, iridium, and silver, and transition metals such as tungsten, cobalt, nickel, and molybdenum.

### [SiC-containing film]

The SiC-containing film of the present embodiment is a SiC-containing film comprising Si and C as main components, wherein a ratio of the number of silicon atoms to the number of carbon atoms (Si/C) is 0.70 or more. A challenge to achieve a SiC-containing film using organic silane as a starting material gas is how to elevate the ratio of a silicon atom in the SiC-containing film. Specifically, for elevating the ratio of a silicon atom in the SiC-containing film, it is necessary to use a silane compound having a high content ratio of a silicon atom. However, for example, monosilane (SiH₄) and disilane (Si₂H₆) having the simplest molecular structure correspond to special high pressure gases designated by the High Pressure Gas Safety Act. Their use is very strictly determined, and their applicability is very poor due to safety management under these circumstances. On the other hand, silane having a large content ratio of an intramolecular hydrocarbon group has higher safety than that of monosilane (SiH₄) or disilane (Si₂H₆). However, the ratio of a silicon atom in a SiC-containing film tends to be decreased depending on the content ratio of an intramolecular hydrocarbon group. Furthermore, a favorable process window (film deposition temperature and film deposition rate) is difficult to obtain when thermal CVD, thermal ALD, or plasma ALD is applied thereto, from the viewpoint of a decomposition temperature or the like. Against this backdrop, the present inventors have found that a SiC-containing film having a relatively high ratio of a silicon atom, i.e., Si/C of 0.70 or more, can be stably obtained by depositing the film by a chemical vapor deposition method or an atomic layer deposition method through thermal reaction using the organic silane represented as described above.

The SiC-containing film of the present embodiment comprises Si and C as main components. In this context, the phrase "comprise Si and C as main components" means that the SiC-containing film comprises 50.0 atm% or more and 99.0 atm% or less of Si and C in total based on the total amount of the SiC-containing film. The SiC-containing film comprises preferably 70.0 atm% or more and 99.0 atm% or less, further preferably 73.0 atm% or more and 95.0 atm% or less, particularly preferably 75.0 atm% or more and 90.0 atm% or less, of Si and C in total from the viewpoint of elevating the ratio of a silicon atom in the film.

The SiC-containing film of the present embodiment is not particularly limited as long as the aforementioned ratio (Si/C) is 0.70 or more. The aforementioned ratio (Si/C) is preferably 0.75 or more, more preferably 0.78 or more, further preferably 0.80 or more. The upper limit value of the aforementioned ratio (Si/C) is not particularly limited and is preferably 1.10 or less, more preferably 1.00 or less, further preferably 0.99 or less, particularly preferably 0.98 or less.

On the other hand, the SiC-containing film of the present embodiment may comprise O in addition to Si and C mentioned above. In this case, a SiCO film may be obtained. An oxygen atom may be supplied at the time of film deposition of the SiC-containing film, or surface oxidation may be performed at the time of atmospheric opening after film deposition. The content ratio of an oxygen atom in the SiC-containing film of the present embodiment is not particularly limited and is preferably 10.0 atm% or more and 30.0 atm% or less, further preferably 15.0 atm% or more and 28.0 atm% or less, particularly preferably 18.0 atm% or more and 25.0 atm% or less, based on the total amount of the SiC-containing film.

The SiC-containing film of the present embodiment preferably substantially comprises no additional atom other than Si, C, and O mentioned above. In this context, the phrase "substantially comprise no" means that the content ratio of an additional atom is less than 3.0 atm% based on the total amount of the SiC-containing film. The content ratio of an additional atom is preferably 1.0 atm% or less, further preferably less than 0.5 atm%, particularly preferably less than 0.1 atm%, most preferably 0.0 atm% or below a detection limit. In this context, examples of the additional atom include N (nitrogen atom) and F (fluorine atom). N, one of the dopants, changes the Fermi level of a film and changes the conductivity of the film. Although F is unlikely to be incorporated into a film, F that has entered a film reduces the permittivity of the film. The SiC-containing film substantially comprises no N or F, whereby electric and optical characteristics are easy to control, and chemical stability and durability tend to be markedly enhanced.

The SiC-containing film of the present embodiment preferably substantially comprises no C-H bond. In this context, the phrase "substantially comprise no" means that a peak of 1100 cm⁻¹ is absent in measurement using a Fourier transform infrared spectrophotometer (FT-IR). In this context, the phrase "peak of 1100 cm⁻¹ is absent" means that the height of the peak at 1100 cm⁻¹ is 5% or less based on the height of a peak at 800 cm⁻¹. The SiC-containing film substantially comprises no C-H bond, whereby electric and optical characteristics are easy to control, and heat resistance tends to be markedly enhanced.

On the other hand, the film thickness of the SiC-containing film of the present embodiment can be appropriately set depending on an application or required performance and is not particularly limited. For example, for a semiconductor or optical system application, the film thickness is generally preferably a monolayer film thickness to 200 nm or less, more preferably 2 nm to 50 nm. For an application requiring mechanical strength or in the case of use as a structure, the film thickness is generally preferably 100 nm to 10 µm, more preferably 300 nm to 5 µm.

As described above in detail, the method for producing a SiC-containing film according to the present embodiment is capable of highly efficiently and conformally depositing a SiC-containing film having a relatively high content ratio of a silicon atom by a production process with high productivity, i.e., at a favorable film deposition rate without excessively elevating a film deposition temperature. The resulting SiC-containing film is a SiC-containing film having a relatively high content ratio of a silicon atom. Hence, the SiC-containing film of the present embodiment and the method for producing the same attain high productivity and low cost.

### Examples

Hereinafter, features of the present invention will be further specifically described with reference to Examples and Comparative Examples. However, the present invention is not limited by these examples by any means. Specifically, materials, amounts of use, ratios, treatment contents, treatment procedures, and the like described in Examples given below can be appropriately changed or modified without departing from the subject matter of the present invention. Values of various production conditions or evaluation results in Examples given below mean preferred upper limit values or preferred lower limit values for the embodiments of the present invention, and a preferred range may be a range defined by the combination of the value of the upper limit or the lower limit described above and a value described below in Examples or the combination of values of Examples.

### <Film deposition apparatus>

The CVD apparatus used was a thermal CVD apparatus manufactured by Japan Advanced Chemicals Ltd. having a configuration equivalent to the one shown in Figure 2. This thermal CVD apparatus has a tubular furnace having an inside diameter of 45 mm and a length of 500 mm as a film deposition chamber (chamber).

### [Example 1]

DSA (disilylacetylene: H₃Si-C≡C-SiH₃) was used as a precursor. In an argon atmosphere, a SiC-containing film having a film thickness of 105.3 nm was deposited on the surface of a silicon wafer substrate for a film deposition time of 10 minutes using the film deposition apparatus. The flow rate of DSA was set to 0.8 sccm, and the flow rate of argon was set to 100 sccm. The inner pressure of the chamber was set to 1.0 Torr, and the film deposition temperature (substrate temperature) was set to 700°C.

### [Example 2]

DSA was used as a precursor. In an argon and hydrogen atmosphere, a SiC-containing film having a film thickness of 215 nm was deposited on the surface of a silicon wafer substrate for a film deposition time of 20 minutes using the film deposition apparatus. The flow rate of DSA was set to 0.8 sccm, and the flow rate of argon and hydrogen was set to 100 sccm. The inner pressure of the chamber was set to 1.0 Torr, and the film deposition temperature (substrate temperature) was set to 700°C.

### [Comparative Example 1]

Vinylsilane (H₂C=CH-SiH₃) was used as a precursor. In a hydrogen atmosphere, a SiC-containing film having a film thickness of 20.7 nm was deposited on the surface of a silicon wafer substrate for a film deposition time of 20 minutes using the film deposition apparatus. The flow rate of vinylsilane was set to 0.8 sccm, and the flow rate of hydrogen was set to 100 sccm. The inner pressure of the chamber was set to 1.0 Torr, and the film deposition temperature (substrate temperature) was set to 800°C.

### [Comparative Example 2]

Vinylsilane was used as a precursor. In an argon atmosphere, a SiC-containing film having a film thickness of 57 nm was deposited on the surface of a silicon wafer substrate for a film deposition time of 10 minutes using the film deposition apparatus. The flow rate of vinylsilane was set to 0.8 sccm, and the flow rate of argon was set to 100 sccm. The inner pressure of the chamber was set to 1.0 Torr, and the film deposition temperature (substrate temperature) was set to 900°C.

### [Comparative Example 3]

Vinylsilane was used as a precursor. In a hydrogen atmosphere, a SiC-containing film having a film thickness of 51.3 nm was deposited on the surface of a silicon wafer substrate for a film deposition time of 15 minutes using the film deposition apparatus. The flow rate of vinylsilane was set to 0.8 sccm, and the flow rate of hydrogen was set to 100 sccm. The inner pressure of the chamber was set to 1.0 Torr, and the film deposition temperature (substrate temperature) was set to 900°C.

### [Comparative Example 4]

Vinylsilane was used as a precursor. In a hydrogen atmosphere, a SiC-containing film having a film thickness of 70.1 nm was deposited on the surface of a silicon wafer substrate for a film deposition time of 10 minutes using the film deposition apparatus. The flow rate of vinylsilane was set to 0.8 sccm, and the flow rate of hydrogen was set to 100 sccm. The inner pressure of the chamber was set to 1.0 Torr, and the film deposition temperature (substrate temperature) was set to 1000°C.

Each SiC-containing film obtained was subjected to surface elemental analysis (XPS).

### <XPS conditions>

Apparatus: PHI 5000 VersaProbe III (manufactured by ULVAC-PHI. INC.)
X ray source: Al, 100 µm○, 25 W, 15 kV
Ion gun: 5 V
Detection angle: 45 deg.
Sample form: A sample was cut into 1 to 2 cm square and fixed to a sample holder using copper tape
Preliminary drying: None
Sputter: None
X ray irradiation system: Area (HP: 1400× 200 µm)
Time per step: 50 (ms)
Cycles: 1
Analysis method: Smoothing, semiquantitative value calculation, and peak fitting were performed using software Multipak. In this operation, shift correction was not performed.

The presence or absence of a C-H bond in each SiC-containing film obtained was measured under the following conditions.

### <Presence or absence of C-H bond>

### FT-IR apparatus: Thermo SCIENTIC NICOLET iS10

The presence or absence of a C-H bond was determined from the presence or absence of a peak of 1100 cm⁻¹ in the obtained spectrum. In this context, the absence of a peak means that the height of the peak at 1100 cm⁻¹ is 5% or less based on the height of a peak at 800 cm⁻¹.

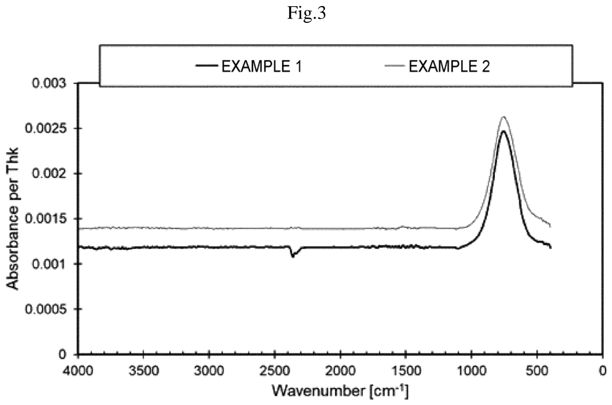

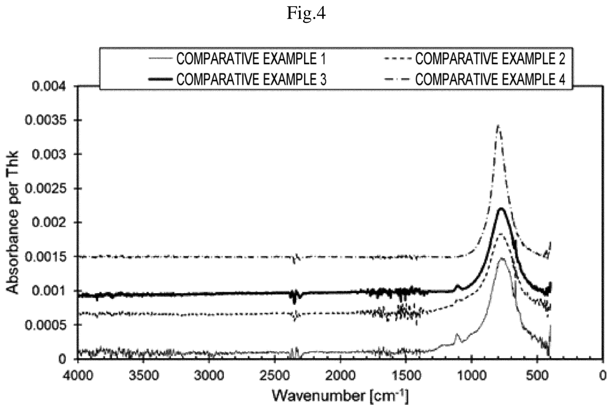

Table 1 shows evaluation results. Figures 3 and 4 show IR measurement results.

**[Table 1]**

| | Film deposition conditions | | | | XPS measurement value (atom%) excluding oxygen of spontaneously oxidized film | | | IR |
|---|---|---|---|---|---|---|---|---|
| | Precursor | Film deposition atmosphere | Temperature (°C) | Time (min) | C | N | Si | Presence or absence of peak of 1100 cm⁻¹ (C-H bond) |
| Example 1 | DSA | Ar | 700 | 10 | 56 | 0 | 44 | Absent |
| Example 2 | DSA | Ar/H₂ | 700 | 20 | 52 | 0 | 48 | Absent |
| Comparative Example 1 | Vinylsilane | H₂ | 800 | 20 | 60 | 0 | 40 | Present |
| Comparative Example 2 | Vinylsilane | Ar | 900 | 10 | 64 | 0 | 36 | Present |
| Comparative Example 3 | Vinylsilane | H₂ | 900 | 15 | 60 | 0 | 40 | Present |
| Comparative Example 4 | Vinylsilane | H₂ | 1000 | 10 | 63 | 0 | 37 | Present |

### Industrial Applicability

The SiC-containing film of the present invention and a method for producing the same are capable of highly efficiently achieving a conformal SiC-containing film having a relatively high content ratio of a silicon atom by a production process with high productivity and as such, can be utilized widely and effectively for various applications requiring the SiC-containing film, for example, insulating films having low permittivity, gas barrier films, covering materials such as graphite members, carbon fibers, and SiC fibers, embedded layers in the surroundings of wiring or each element within semiconductor devices, fine multilayer-structure films or various protective films in large-scale integrated circuits and the like for use in semiconductors, interlayer insulating films, etching stopper films, barrier insulating films, waveguides or their protective films, and electrode materials.

### Reference Signs List

100: Film deposition apparatus for SiC-containing film

## Claims

1. A method for producing a SiC-containing film, comprising the steps of:
providing XpHnSim-C≡C-SiqHrXs (wherein m is an integer of 0 or larger and 4 or smaller, each of n and p is an integer of 0 or larger and 2m + 1 or smaller and satisfies n + p = 2m + 1, q is an integer of 1 or larger and 4 or smaller, each of r and s is an integer of 0 or larger and 2q + 1 or smaller and satisfies r + s = 2q + 1, and each X is independently a halogen element selected from F, Cl, Br, and I) as a starting material gas; and
supplying the starting material gas into a chamber containing a workpiece having a surface for film deposition, and depositing a SiC-containing film on the surface for film deposition by a chemical vapor deposition method or an atomic layer deposition method through thermal reaction, the SiC-containing film comprising Si and C as main components, wherein a ratio of the number of silicon atoms to the number of carbon atoms (Si/C) is 0.70 or more.

2. The method for producing a SiC-containing film according to claim 1, wherein
in the film deposition step, the SiC-containing film is deposited in an inert gas atmosphere and/or in a hydrogen gas atmosphere.

3. The method for producing a SiC-containing film according to claim 1, wherein
the SiC-containing film comprises 50.0 atm% or more and 99.0 atm% or less of Si and C in total.

4. The method for producing a SiC-containing film according to claim 1, wherein
the SiC-containing film substantially comprises no C-H bond.

5. The method for producing a SiC-containing film according to claim 1, wherein
the SiC-containing film substantially comprises no nitrogen atom.

6. The method for producing a SiC-containing film according to claim 1, wherein
the ratio (Si/C) of the SiC-containing film is 0.70 or more and 0.99 or less.

7. The method for producing a SiC-containing film according to claim 1, wherein
in the film deposition step, the SiC-containing film is deposited under a condition of 300°C or higher.

8. The method for producing a SiC-containing film according to claim 1, wherein
in the film deposition step, the SiC-containing film is deposited under a condition of 1200°C or lower.

9. A SiC-containing film
comprising Si and C as main components, wherein a ratio of the number of silicon atoms to the number of carbon atoms (Si/C) is 0.70 or more.

10. The SiC-containing film according to claim 9, wherein
the SiC-containing film is derived from XpHnSim-C≡C-SiqHrXs (wherein m is an integer of 0 or larger and 4 or smaller, each of n and p is an integer of 0 or larger and 2m + 1 or smaller and satisfies n + p = 2m + 1, q is an integer of 1 or larger and 4 or smaller, each of r and s is an integer of 0 or larger and 2q + 1 or smaller and satisfies r + s = 2q + 1, and each X is independently a halogen element selected from F, Cl, Br, and I).

11. The SiC-containing film according to claim 9, wherein
the SiC-containing film comprises 50.0 atm% or more and 99.0 atm% or less of Si and C in total.

12. The SiC-containing film according to claim 9, wherein
the SiC-containing film substantially comprises no C-H bond.

13. The SiC-containing film according to claim 9, wherein
the SiC-containing film substantially comprises no nitrogen atom.

14. The SiC-containing film according to claim 9, wherein
the ratio (Si/C) is 0.70 or more and 0.99 or less.
